# EUROPÄISCHE PATENTSCHRIFT

(11) **EP 0 392 062 B1**
(45) Veröffentlichungstag und Bekanntmachung des Hinweises auf die Patenterteilung: **22.06.1994**
(21) Anmeldenummer: 89106663.1
(22) Anmeldetag: 14.04.1989
(51) Int. Cl.: H03F 3/08, H03F 1/48, H03F 1/34

(54) **Integrierbare Verstärkerschaltung**
Integrable amplifier circuit
Circuit amplificateur intégrable

(43) Veröffentlichungstag der Anmeldung: 17.10.1990
(73) Patentinhaber: SIEMENS AKTIENGESELLSCHAFT, 80333 München (DE)
(72) Erfinder: Bichler, Helmut, D-8032 Gräfelfing (DE)

(56) Entgegenhaltungen:
- DE-A- 2 748 647
- US-A- 3 968 361
- US-A- 4 042 886
- US-A- 4 092 611
- US-A- 4 481 480

## Beschreibung

Die Erfindung betrifft eine integrierbare Verstärkerschaltung nach dem Oberbegriff des Patentanspruches 1.

In einer Vielzahl von Anwendungen werden Verstärkerschaltungen benötigt, um einen geringen Pegel eines Eingangssignales anzuheben. Dabei kommt es häufig vor, daß dem Eingangssignal störende Gleichanteile überlagert sind. Diese können dazu führen, daß beispielsweise nachfolgende Stufen und/oder die Verstärkerschaltung selbst übersteuert und damit eine einwandfreie Weiterverarbeitung des Signales unterbunden wird. Üblicherweise wird deshalb der Verstärkerschaltung ein RC-Hochpaß vorgeschaltet. Das bringt allerdings den Nachteil mit sich, daß die Signalquelle mit einem frequenzabhängigen, überwiegend nicht reellen Widerstand abgeschlossen ist. Bei vielen Sensoren, beispielsweise bei Fotodioden, ist ein konstanter, möglichst reeller Abschlußwiderstand anzustreben, um eine möglichst geringe Beeinflussung des Signales zu ereichen (siehe z.B. das Dokument DE-A-2748647).

Aufgabe der Erfindung ist es daher, eine Verstärkerschaltung anzugeben, die im Signal enthaltene Gleichanteile unterdrückt und die einen möglichst konstanten Eingangswiderstand aufweist.

Diese Aufgabe wird bei einer gattungsgemäßen Verstärkerschaltung durch die kennzeichnenden Merkmale des Patentanspruches 1 gelöst. Ausgestaltungen und Weiterbildungen des Erfindungsgedankens sind in den Unteransprüchen gekennzeichnet.

Vorteile der Erfindung sind eine hohe Übersteuerungsfestigkeit und eine hohe Grundverstärkung.

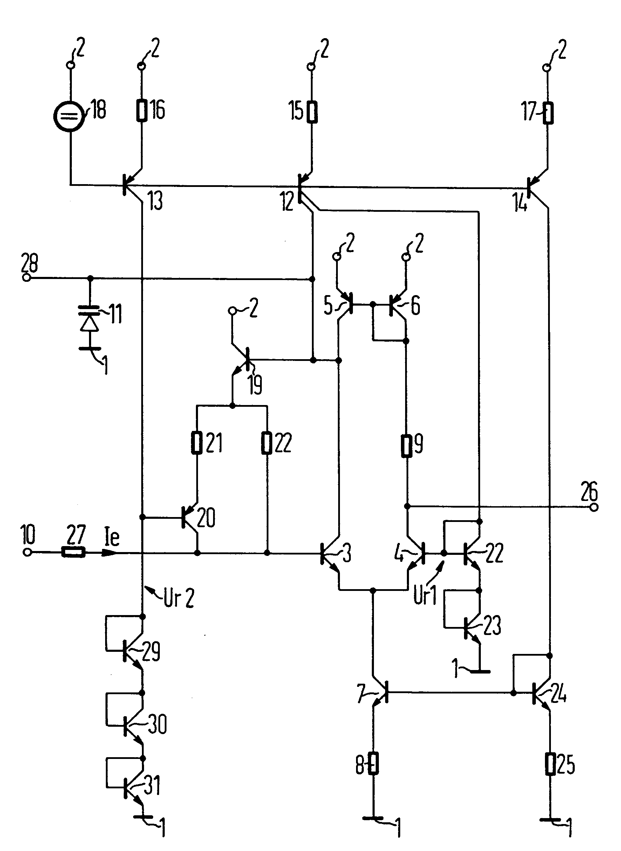

Die Erfindung wird nachfolgend anhand des in der einzigen Figur der Zeichnung dargestellten Ausführungsbeispieles näher erläutert.

Das Ausführungsbeispiel gemäß der Zeichnung zeigt eine Differenzverstärkerstufe mit einem aus zwei emittergekoppelten NPN-Transistoren 3, 4 bestehenden Transistorpaar, wobei die beiden Kollektoren jeweils mit einem Zweig eines Stromspiegels verbunden sind. Dabei ist der den invertierenden Ausgang der Differenzverstärkerstufe bildende Kollektor des Transistors 4 über einen Widerstand 9 mit dem Eingangszweig des Stromspiegels verbunden. Der Eingangszweig des Stromspiegels weist einen durch Verbinden von Basis und Kollektor als Diode in Durchlaßrichtung betriebenen und auf ein positives Versorgungspotential 2 führenden PNP-Transistor 6 auf. Die Basis des Transistors 6 ist mit der Basis eines den Ausgangszweig des Stromspiegels bildenden PNP-Transistors 5 verbunden, dessen Emitter ebenfalls mit dem Versorgungspotential 2 beaufschlagt und dessen Kollektor mit dem Kollektor des Transistors 3 verschaltet ist. Die Basis des Transistors 4, dessen Kollektor sowohl den invertierten Ausgang der Differenzverstärkerstufe als auch den Ausgang 26 der Verstärkerschaltung bildet, ist über zwei hintereinander geschaltete, durch Verbinden von Basis und Kollektor jeweils als Diode in Durchlaßrichtung betriebene NPN-Transistoren 22 und 23 mit einem Bezugspotential 1 gekoppelt. Die Basis des Transistors 4, die als nichtinvertierender Eingang der Differenzverstärkerstufe vorgesehen ist, wird zudem durch einen ersten Ausgang einer Strombank gespeist. Die Strombank des vorliegenden Ausführungsbeispiels weist insgesamt vier Ausgänge auf. Der erste Ausgang wird dabei durch einen Kollektor eines PNP-Transistors 12 gebildet, dessen zweiter Kollektor als zweiter Ausgang mit dem Kollektor des Transistors 3 verschaltet ist. Ein dritter Ausgang der Strombank, nämlich der Kollektor eines PNP-Transisotrs 13, ist über drei hintereinander geschaltete, jeweils durch Verbinden von Basis und Kollektor als Dioden in Durchlaßrichtung betriebene NPN-Transistoren 29, 30, 31 auf Bezugspotential 1 geführt. Der vierte Ausgang der Strombank, der durch den Kollektor eines PNP-Transistors 14 gegeben ist, ist über einen durch Verbinden von Kollektor und Basis als Diode in Durchlaßrichtung betriebenen NPN-Transistor 24 und einen in Reihe dazu liegenden Widerstand 25 ebenfalls mit dem Bezugspotential 1 verbunden. Die Basis des Transistors 24 ist mit der Basis eines NPN-Transistors 7 verschaltet, dessen Emitter über einen Widerstand 8 mit dem Bezugspotential 1 gekoppelt und dessen Kollektor mit den gekoppelten Emittern der Transistoren 3 und 4 verschaltet ist. Darüber hinaus sind bei der Strombank jeweils die Emitter der Transistoren 12, 13, 14 über einen Widerstand 15, 16, 17 an das Versorgungspotential 2 gelegt und die Basen dieser Transistoren zusammen an eine Vorspannungsquelle 18 angeschlossen, deren anderer Anschluß an dem Versorgungspotential 2 liegt.

An den Kollektor des Transistors 3 als nichtinvertierendem Ausgang der Differenzverstärkerstufe ist zudem die Basis eines NPN-Transistors 19 angeschlossen, dessen Kollektor mit dem Versorgungspotential 2 beaufschlagt ist. Der Emitter des Transistors 19 ist zum einen über einen Widerstand 22 und zum anderen über eine Serienschaltung aus einem Widerstand 21 und der Emitter-Kollektor-Strecke eines PNP-Transistors 20 mit der Basis des Transistors 3 verbunden. Die Basis des Transistors 20 ist dabei mit dem dritten Ausgang der Strombank verschaltet. Des weiteren ist der invertierende Eingang der Differenzverstärkerstufe, nämlich die Basis des Transistors 3, über einen Widerstand 27 an den Eingang 10 der Verstärkerschaltung geführt. Schließlich ist zwischen Bezugspotential 1 und den nicht invertierten Ausgang der Differenzverstärkerstufe eine Kapazitätsdiode 11 geschaltet, wobei der nichtinvertierte Ausgang zusätzlich mit einer Anschlußklemme 28 verbunden ist.

Die Funktionsweise der gezeigten Verstärkerschaltung beruht auf einer frequenzabhängigen Arbeitspunkteinstellung der Differenzverstärkerstufe. Die Arbeitspunkteinstellung erfolgt zum einen fest durch Beaufschlagung des nicht invertierenden Eingangs der Differenzverstärkerstufe mit einem ersten Referenzpotential Ur1 und zum anderen erfindungsgemäß dadurch, daß zwischen nichtinvertiertem Ausgang und invertierendem Eingang ein aktives Gegenkopplungsnetzwerk vorgesehen ist. Das aktive Gegenkopplungsnetzwerk besteht aus den Transistoren 19 und 20, den Widerständen 21 und 22, der Kapazitätsdiode 11 und einer Stromquelle, die durch den zweiten Ausgang der Strombank gegeben ist. Dabei bilden die Kapazitätsdiode 11 und die durch den zweiten Stromausgang der Strombank gegebene Stromquelle ein Tiefpaßfilter, das zwischen den nichtinvertierten Ausgang der Differenzverstärkerstufe und der Basis des Transistors 19 geschaltet ist. Mit diesem tiefpaßgefilterten Ausgangssignal wird mittels des Transistors 19 der vom Versorgungspotential 2 zum invertierenden Eingang fließende Strom geregelt. Dieser Strom läßt sich in zwei Teilströme aufspalten, nämlich in einen Teilstrom durch den Widerstand 22 und den Teilstrom durch den Widerstand 21, wobei der Strom durch den Widerstand 21 durch den Transistor 20 ebenfalls regelbar ist. Da die Basis des Transistors 20 mit einem zweiten Referenzpotential Ur2 beaufschlagt ist, wird bei ansteigendem Potential am nicht invertierten Ausgang der Differenzverstärkerstufe auch das Emitterpotential des Transistors 19 und damit auch das Emitterpotential des Transistors 20 angehoben, wodurch der Transistor 20 stärker leitend wird und dadurch der über den Widerstand 21 fließende Strom vergrößert wird. Da der zwischen dem Versorgungspotential 2 und dem invertierenden Eingang der Differenzverstärkerstufe fließende Strom gegenphasig zu einem Eingang in den invertierenden Eingang der Differenzverstärkerstufe fließenden Eingangsstrom Ie ist, ergibt sich effektiv eine Subtraktion beider Ströme. Das Tiefpaßverhalten des aktiven Gegenkopplungszweiges bewirkt damit insgesamt ein Hochpaßverhalten.

Die Erfindung ausgestaltend werden die beiden Referenzspannungen Ur1, Ur2 durch Spannungsabfall an Diodenstrecken erzeugt. Zu diesem Zweck sind im vorliegenden Ausführungsbeispiel zur Erzeugung der ersten Referenzspannung Ur1 zwei hintereinander geschaltete und von einer Stromquelle gespeiste Dioden, nämlich die entsprechend geschalteten Transistoren 22 und 23, und zur Erzeugung der zweiten Referenzspannung drei hintereinander geschaltete und durch eine Stromquelle gespeiste Dioden, nämlich die entsprechend verschalteten Transistoren 29, 30 und 31, vorgesehen. Der Vorteil besteht nun darin, daß die Dioden in integrierter Technik sehr einfach auszuführen sind und einen annähernd gleichen Temperaturkoeffizienten aufweisen, so daß nach Weiterverarbeitung durch die Differenzverstärkerstufe insgesamt der Temperaturkoeffizient annähernd gleich Null wird. Des weiteren sorgt auch eine Realisierung der Stromquellen als Strombank vorteilhafterweise für ein gutes Gleichtaktverhalten.

Die Erfindung ausgestaltend ist als Kapazität die Kapazitätsdiode 11 vorgesehen. Das bringt den Vorteil mit sich, daß keine externen Bauelemente benötigt werden. Jedoch ist es auch möglich, externe Elemente zur Grenzfrequenzeinstellung hinzuzuschalten, indem beispielsweise der Kapazitätsdiode 11 extern ein Kondensator parallel geschaltet wird. Dabei kann jedoch auch die interne Kapazitätsdiode 11 entfallen.

Die in dem Ausführungsbeispiel gemäß der Zeichnung gezeigte Differenzverstärkerstufe stellt eine bevorzugte Ausführungsform dar, jedoch sind auch weitere Ausführungsformen uneingeschränkt anwendbar. Der Vorteil der gezeigten Ausführungsform liegt in einem sehr geringen schaltungstechnischen Aufwand, wobei durch den Stromspiegel mit den Transistoren 5 und 6 sowie durch den Widerstand 9 neben einer ausreichenden Strombegrenzung ein Mittel zur Arbeitspunkt - und Verstärkungseinstellung gegeben ist.

Abschließend sei bemerkt, daß neben einer Realisierung in Bipolartechnik auch eine Realisierung in MOS-Technik möglich ist.

## Patentansprüche

1. Integrierbare Verstärkerschaltung mit einer Differenzverstärkerstufe (3 bis 9), deren nicht-invertierender Eingang mit einem ersten Referenzpotential (Ur1) und deren invertierender Eingang mit einem Eingangsstrom (Ie) beaufschlagt ist,
**gekennzeichnet**
durch eine Kapazität (11), die zwischen den nicht-invertierten Ausgang der Differenzverstärkerstufe (3 bis 9) und einem Bezugspotential (1) geschaltet ist,
durch eine Stromquelle (18, 15, 12), die zwischen nicht-invertiertem Ausgang der Differenzverstärkerstufe (3 bis 9) und einem Versorgungspotential (2) geschaltet ist,
durch einen ersten Transistor (19) des einen Leitungstyps, dessen Kollektor mit dem Versorgungspotential (2) und dessen Basis mit dem nicht-invertierten Ausgang der Differenzverstärkerstufe (3 bis 9) verbunden ist,
durch einen zweiten Transistor (20) des anderen Leitungstyps, dessen Kollektor mit dem invertierenden Eingang der Differenzverstärkerstufe (3 bis 9) verbunden und dessen Basis mit einem zweiten Referenzpotential (Ur2) beaufschlagt ist und durch einen Widerstand (21), der zwischen die Emitter von erstem und zweitem Transistor (19, 20) geschaltet ist.

2. Integrierbare Verstärkerschaltung nach Anspruch 1,
**gekennzeichnet**
durch einen weiteren Widerstand (22), der zwischen Emitter des ersten Transistors (19) und invertierendem Eingang der Differenzverstärkerstufe (3 bis 9) geschaltet ist.

3. Integrierbare Verstärkerschaltung nach Anspruch 1 oder 2,
**dadurch gekennzeichnet**,
daß als Kapazität eine Kapazitätsdiode (11) vorgesehen ist.

4. Integrierbare Verstärkerschaltung nach einem der Ansprüche 1 bis 3, **dadurch gekennzeichnet**,
daß zur Erzeugung der beiden Referenzpontentiale (Ur1; Ur2) jeweils eine oder mehrere in Reihe geschaltete, mit einem Konstantstrom beaufschlagte Diode(n) (19 bis 23) vorgesehen ist/sind.

5. Integrierbare Verstärkerschaltung nach einem der Ansprüche 1 bis 5,
**dadurch gekennzeichnet**,
daß als Differenzverstärkerstufe (3 bis 9) ein emittergekoppeltes, aus einer weiteren Stromquelle gespeistes Transistorpaar (3, 4) vorgesehen ist, dessen Kollektoren jeweils mit einem Zweig eines Stromspiegels (5, 6) verbunden sind, wobei der den invertierenden Ausgang der Differenzverstärkerstufe (3 bis 9) bildende Kollektor eines der beiden Transistoren des Transistorpaares (3, 4) über einen Widerstand (9) mit dem Eingangszweig des Stromspiegels (5, 6) verbunden ist.

6. Integrierbare Verstärkerschaltung nach einem der Anspruche 1 bis 6,
**dadurch gekennzeichnet**,
daß mindestens zwei der Stromquellen durch die Ausgangszweige einer Strombank (12 bis 18, 7, 8, 24, 25) gegeben sind.

## Claims

1. Amplifier circuit, which can be integrated, having a differential-amplifier stage (3 to 9) whose non-inverting input has a first reference potential (Ur1) applied to it and whose inverting input has an input current (Ie) applied to it, characterized by a capacitor (11) which is connected between the non-inverted output of the differential-amplifier stage (3 to 9) and a datum potential (1), by a current source (18, 15, 12) which is connected between the non-inverted output of the differential-amplifier stage (3 to 9) and a supply potential (2), by a first transistor (19) of the one conductance type, whose collector is connected to the supply potential (2) and whose base is connected to the non-inverted output of the differential-amplifier stage (3 to 9), by a second transistor (20) of the other conductance type, whose collector is connected to the inverting input of the differential-amplifier stage (3 to 9) and whose base has a second reference potential (Ur2) applied to it, and by a resistor (21) which is connected between the emitters of the first and second transistors (19, 20).

2. Amplifier circuit, which can be integrated, according to Claim 1, characterized by a further resistor (22) which is connected between the emitter of the first transistor (19) and the inverting input of the differential-amplifier stage (3 to 9).

3. Amplifier circuit, which can be integrated, according to Claim 1 or 2, characterized in that a capacitance diode (11) is provided as the capacitance.

4. Amplifier circuit, which can be integrated, according to one of Claims 1 to 3, characterized in that in each case one or more diodes (19 to 23), which are connected in series and to which a constant current is applied, is/are provided for producing the two reference potentials (Ur1; Ur2).

5. Amplifier circuit, which can be integrated, according to one of Claims 1 to 5, characterized in that an emitter-coupled transistor pair (3, 4) is provided as the differential-amplifier stage (3 to 9), which transistor pair (3, 4) is supplied from a further current source and whose collectors are in each case connected to a branch of a current mirror (5, 6), the collector, which forms the inverted output of the differential-amplifier stage (3 to 9), of one of the two transistors of the transistor pair (3, 4) being connected to the input branch of the current mirror (5, 6) via a resistor (9).

6. Amplifier circuit, which can be integrated, according to one of Claims 1 to 6, characterized in that at least two of the current sources are provided by the output branches of a current bank (12 to 18, 7, 8, 24, 25).

## Revendications

1. Circuit amplificateur intégrable, comportant un étage amplificateur différentiel (3 à 9), dont l'entrée non inverseuse est chargée par un premier potentiel de référence (Ur1) et dont l'entrée inverseuse est chargée par un courant d'entrée (Ie), caractérisé
par une capacité (11), qui est branchée entre la sortie non inverseuse de l'étage amplificateur différentiel (3 à 9) et un potentiel de référence,
par une source de courant (18, 15, 12), qui est branchée entre la sortie non inverseuse de l'étage amplificateur différentiel (3 à 9) et un potentiel d'alimentation (2),
par un premier transistor (19) possédant un premier type de conduction et dont le collecteur est placé au potentiel d'alimentation (2) et la base est reliée à la sortie non inverseuse de l'étage amplificateur différentiel (3 à 9),
par un second transistor (20) possédant l'autre type de conduction et dont le collecteur est relié à l'entrée inverseuse de l'étage amplificateur différentiel (3 à 9) et dont la base est chargée par le second potentiel de référence (Ur2), et
par une résistance (21), qui est branchée entre les émetteurs des premier et second transistors (19, 20).

2. Circuit amplificateur intégrable selon la revendication 1, caractérisé par une autre résistance (22), qui est branchée entre l'émetteur du premier transistor (19) et l'entrée inverseuse de l'étage amplificateur différentiel (3 à 9).

3. Circuit amplificateur intégrable selon la revendication 1 ou 2, caractérisé par le fait qu'il est prévu comme capacité, une diode capacitive (11).

4. Circuit amplificateur intégrable selon l'une des revendications 1 à 3, caractérisé par le fait que pour la production des deux potentiels de référence (Ur1; Ur2), il est prévu respectivement une ou plusieurs diodes (19 à 23) branchées en série et chargées par un courant constant.

5. Circuit amplificateur intégrable selon l'une des revendications 1 à 5, caractérisé par le fait qu'il est prévu comme étage amplificateur différentiel (3 à 9), un couple de transistors (3, 4) à émetteurs couplés, qui sont alimentés par une autre source de courant et dont les collecteurs sont reliés respectivement à une branche d'un miroir de courant (5, 6), le collecteur, qui constitue la sortie inverseuse de l'étage amplificateur différentiel (3 à 9) de l'un des deux transistors du couple de transistors (3, 4), étant relié par l'intermédiaire d'une résistance (9) à la borne d'entrée du miroir de courant (5, 6).

6. Circuit amplificateur intégrable selon l'une des revendications 1 à 6, caractérisé par le fait qu'au moins deux des sources de courant sont formées par les branches de sortie d'un module de délivrance de courant (12 à 18, 7, 8, 24, 25).
